(19) **Europäisches Patentamt**
**European Patent Office**
**Office européen des brevets**

(11) **EP 4 513 194 A1**

(12) **EUROPEAN PATENT APPLICATION**
published in accordance with Art. 153(4) EPC

(43) Date of publication:
**26.02.2025 Bulletin 2025/09**

(21) Application number: **23791578.0**

(22) Date of filing: **16.03.2023**

(51) International Patent Classification (IPC):
**G01N 35/02** (2006.01)

(52) Cooperative Patent Classification (CPC):
**G01N 35/02**

(86) International application number:
**PCT/JP2023/010365**

(87) International publication number:
**WO 2023/203925 (26.10.2023 Gazette 2023/43)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **20.04.2022 JP 2022069311**

(71) Applicant: **HITACHI HIGH-TECH CORPORATION Tokyo 105-6409 (JP)**

(72) Inventors:
• **SUGIYAMA, Yoshikazu**
Tokyo 100-8280 (JP)
• **KANAI, Hisaaki**
Tokyo 100-8280 (JP)
• **TANAKA, Yuto**
Tokyo 105-6409 (JP)
• **YOSHIDA, Gorou**
Tokyo 105-6409 (JP)
• **ONISHI, Fujio**
Tokyo 105-6409 (JP)

(74) Representative: **Strehl Schübel-Hopf & Partner Maximilianstrasse 54 80538 München (DE)**

(54) **AUTOMATIC ANALYSIS DEVICE**

(57) An object of the invention is to provide an automatic analyzer capable of agitating a sample and a reagent by using ultrasonic waves having stable sound pressure, regardless of a characteristic variation of a piezoelectric element. To this end, the invention provides an automatic analyzer for agitating a sample and a reagent by using ultrasonic waves generated by driving a piezoelectric element. An amplifier configured to drive the piezoelectric element includes a voltage detection unit configured to detect a voltage applied to the piezoelectric element, a current detection unit configured to detect a current flowing through the piezoelectric element, a calculation unit configured to calculate effective electrical power based on a detected voltage detected by the voltage detection unit and a detected current detected by the current detection unit and determine an adjustment signal using the calculated effective electrical power and a predetermined target electrical power, and an impedance matching circuit configured to adjust output electrical power of the amplifier by changing a reactance component based on the adjustment signal determined by the calculation unit.

[FIG. 3]

**Description**

**Technical Field**

The present invention relates to an automatic analyzer.

**Background Art**

A technique in which by irradiating a reaction liquid in a reaction vessel with ultrasonic waves, a flow is generated in a sample and a reagent contained in the reaction liquid, and the sample and the reagent are agitated has been developed and already implemented in an automatic analyzer. In the agitating method using ultrasonic waves, the reaction liquid can be agitated without contact, so that carry-over of the sample and the reagent due to use of an agitating rod or the like and introduction of washing water can be avoided. In the case of the agitating method using ultrasonic waves, due to factors such as variations in resonance frequency of a piezoelectric element that generates ultrasonic waves, an intensity of the generated ultrasonic waves varies, and therefore stable agitating may not be achieved. Therefore, for example, Patent Literature 1 discloses an automatic analyzer that applies a voltage that is frequency-modulated with a frequency in any frequency range to a piezoelectric element.

**Citation List**

**Patent Literature**

PTL 1: WO01/63300

**Summary of Invention**

**Technical Problem**

As in the technique described in Patent Literature 1, when attempting to cover a low frequency side by frequency modulation centered on a nominal value of the resonance frequency, the frequency must be expanded beyond a maximum frequency deviation $\Delta F$. However, when an output frequency is equal to or higher than $\Delta F$, a ratio of a time during which the piezoelectric element is driven at a frequency other than the resonance frequency increases, resulting in a decrease in efficiency.

An object of the invention is to provide an automatic analyzer capable of agitating a sample and a reagent by using ultrasonic waves having stable sound pressure, regardless of a characteristic variation of a piezoelectric element.

**Solution to Problem**

In order to solve the above problems, the invention provides an automatic analyzer for agitating a sample and a reagent by using ultrasonic waves generated by driving a piezoelectric element. An amplifier configured to drive the piezoelectric element includes a voltage detection unit configured to detect a voltage applied to the piezoelectric element, a current detection unit configured to detect a current flowing through the piezoelectric element, a calculation unit configured to calculate effective electrical power based on a detected voltage detected by the voltage detection unit and a detected current detected by the current detection unit and determine an adjustment signal using the calculated effective electrical power and a predetermined target electrical power, and an impedance matching circuit configured to adjust output electrical power of the amplifier by changing a reactance component based on the adjustment signal determined by the calculation unit.

**Advantageous Effects of Invention**

According to the invention, an automatic analyzer capable of agitating a sample and a reagent by using ultrasonic waves having stable sound pressure, regardless of a characteristic variation of a piezoelectric element can be provided.

**Brief Description of Drawings**

[FIG. 1] FIG. 1 is a schematic configuration diagram of an automatic analyzer according to the present embodiment.

[FIG. 2] FIG. 2 is a diagram illustrating a configuration of an agitating unit, and an amplifier and a mechanism control unit connected thereto.

[FIG. 3] FIG. 3 is a diagram illustrating an electrical circuit of the amplifier, and the agitating unit and the mechanism control unit connected thereto.

[FIG. 4] FIG. 4 is a diagram illustrating configurations of a voltage detection unit, a current detection element, a current detection unit, and a calculation unit of an amplifier according to Embodiment 1.

[FIG. 5] FIG. 5 is an example of a table that stores a target electrical power value according to Embodiment 1.

[FIG. 6] FIG. 6 is a diagram illustrating a configuration of a variable reactance impedance matching circuit according to Embodiment 1.

[FIG. 7] FIG. 7 is a flowchart illustrating a process of initial setting performed by a calculation unit.

[FIG. 8] FIG. 8 is a flowchart illustrating a process of electrical power adjustment performed by the calculation unit.

[FIG. 9] FIG. 9 is a timing chart illustrating a timing of a training sequence.

[FIG. 10] FIG. 10 is an example of a table that stores a target electrical power value according to Embodiment 2.

[FIG. 11] FIG. 11 is a diagram illustrating a configuration of a variable reactance impedance matching circuit according to Embodiment 3.

[FIG. 12] FIG. 12 is a diagram illustrating configurations of a voltage detection unit, a current detection element, a current detection unit, and a calculation unit of an amplifier according to Embodiment 4.

[FIG. 13] FIG. 13 is a flowchart illustrating a process of initial setting of frequency search electrical power adjustment performed by the calculation unit.

[FIG. 14] FIG. 14 is a diagram illustrating an electrical power adjustment module used in the frequency search electrical power adjustment.

[FIG. 15] FIG. 15 is a flowchart illustrating a process of the frequency search electrical power adjustment performed by the calculation unit.

[FIG. 16] FIG. 16 is a timing chart illustrating a timing of electrical power adjustment.

[FIG. 17] FIG. 17 is a diagram illustrating a signal transmitted from a mechanism control unit to the amplifier.

**Description of Embodiments**

Hereinafter, embodiments of the invention will be described with reference to the drawings.

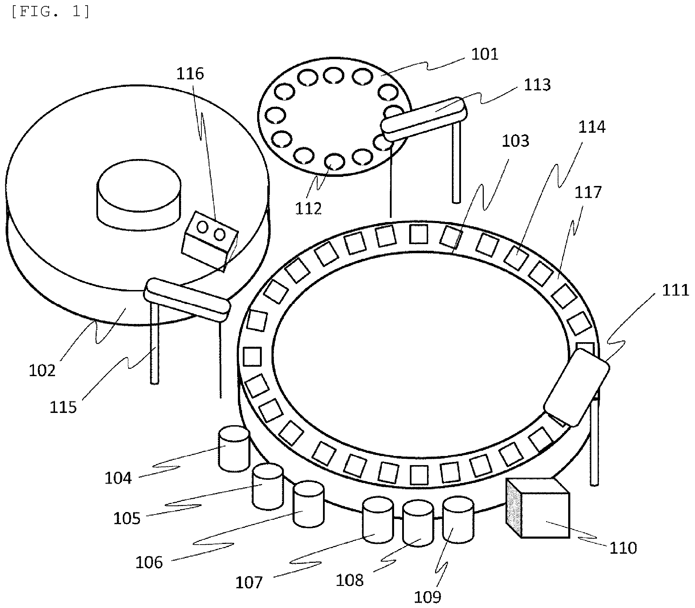

FIG. 1 is a schematic configuration diagram of an automatic analyzer according to the present embodiment. As shown in FIG. 1, the automatic analyzer includes a sample storage unit 101, a reagent storage unit 102, a reaction unit 103, agitating units 104 to 109, an analysis unit 110, a washing unit 111, a sample aliquoting mechanism 113, and a reagent aliquoting mechanism 115. Although not shown in FIG. 1, the automatic analyzer further includes a mechanism control unit 4 (a host computer) including an electronic circuit or a storage device, and the mechanism control unit 4 controls an operation of each unit and each mechanism.

A sample container such as a test tube is stored in the sample storage unit 101, and a sample 112 is placed in the sample container. The reaction unit 103 includes a rotatable reaction disk, and reaction vessels 114 (reaction cells) are arranged circumferentially on the reaction disk. The reaction disk has a constant temperature bath for holding constant temperature water at a specified temperature, and the reaction vessel 114 is kept at a predetermined temperature by the constant temperature water circulating in the constant temperature bath contacting the reaction vessel 114. The sample aliquoting mechanism 113 aspirates an amount of the sample 112 required for analysis from the sample container, and aliquots the aspirated sample 112 into the reaction vessel 114 on the reaction unit 103. The reagent aliquoting mechanism 115 aspirates an amount of reagent 116 required for analysis from the reagent storage unit 102, and aliquots the aspirated reagent 116 into the reaction vessel 114. A plurality of agitating units 104 to 109 are provided side by side on an outer circumferential side of the reaction disk, and agitate the sample 112 and the reagent 116 aliquoted into the reaction vessel 114, respectively. The analysis unit 110 performs component analysis by measuring an absorbance of a reaction liquid of the sample 112 and the reagent 116 in which a reaction is promoted. The washing unit 111 washes the reaction vessel 114 after the absorbance measurement is completed. The next sample 112 is aliquoted by the sample aliquoting mechanism 113 into the reaction vessel 114 washed by the washing unit 111, and the same sequence is repeated thereafter.

Here, the agitating units 104 to 109 irradiate the reaction vessel 114 with ultrasonic waves, and agitate the sample 112 and the reagent 116 without contact by using vibration, acoustic flow, acoustic radiation pressure, and the like. By providing a plurality of agitating units, the sample 112 and the reagent 116 can be efficiently agitated to achieve a high processing capacity. In the present embodiment, the constant temperature water is used as a liquid that mediates sound waves, and water other than the constant temperature water or liquid other than the water may also be used. When vibration or the like is applied to the sample 112 and the reagent 116, sound waves other than ultrasonic waves may be used.

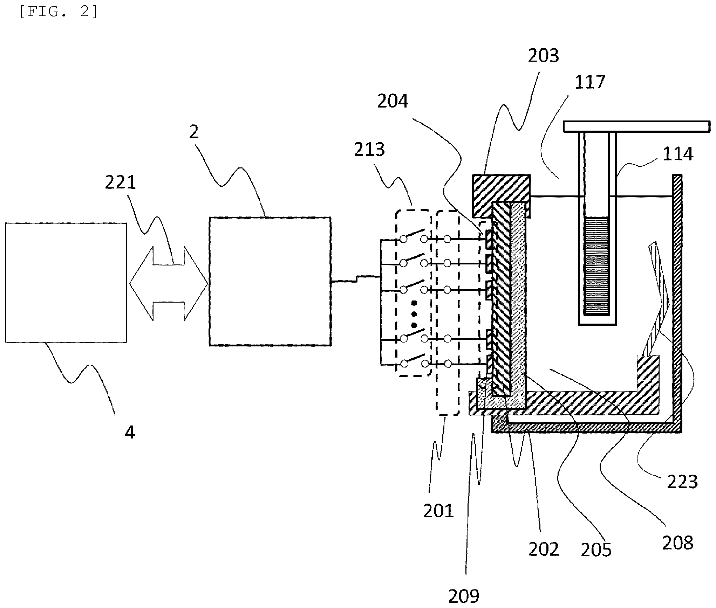

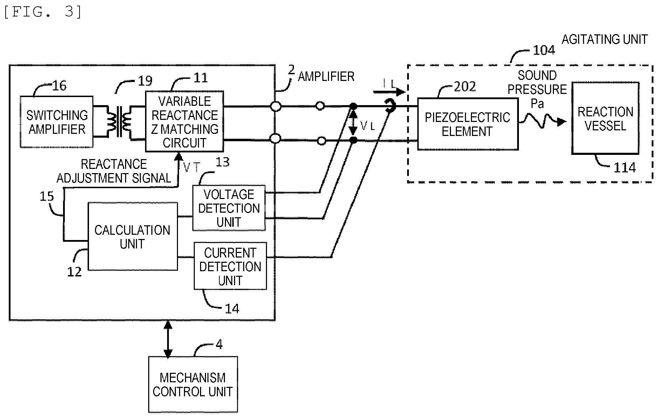

FIG. 2 is a diagram illustrating a configuration of an agitating unit and an amplifier and a mechanism control unit connected thereto. FIG. 2 mainly illustrates a vertical cross section of the agitating unit 104 along a radial direction of the reaction unit 103, and a specific configuration of an amplifier 2 is illustrated in FIG. 3 and subsequent drawings. In the following, the agitating unit 104 will be described as an example, and the same applies to the agitating units 105 to 109.

As illustrated in FIG. 2, the agitating unit 104 includes a piezoelectric element 202 that generates ultrasonic waves, a jig 203 for attaching the piezoelectric element 202 to a constant temperature bath 117, a reflection plate 223 that reflects the ultrasonic waves transmitted through the reaction vessel 114 or the like toward the reaction vessel 114, and a connector 201 that electrically connects the piezoelectric element 202 and an amplifier 2 side. The piezoelectric element 202 includes split electrodes 204 and 209 which are provided on one surface (an air side surface) and come into contact with air, and a constant temperature water side electrode 205 which is provided on the other surface (a constant temperature water side surface) and comes into contact with constant temperature water 208. A part of the constant temperature water side electrode 205 is folded back to the air side surface along a lower end surface of the piezoelectric element 202.

The split electrodes 204 and 209 are divided into a plurality of electrodes at different height positions. In the present embodiment, an example in which thirteen split electrodes are provided (only a part is illustrated in FIG. 2 and the like) will be described, and the number of split electrodes is not limited to thirteen. Dimensions and shapes of the respective split electrodes can be individually and freely designed, and in the present embodiment, the first to twelfth split electrodes 204 from the top have the same shape (the same width and length), and only the thirteenth (the lowermost) split electrode 209 is formed to be slightly longer than the other split electrodes 204. Each split electrode is connected to a corresponding pin of the connector 201 in a one-to-one correspondence.

The amplifier 2 is provided with an interface unit 221 connected to the mechanism control unit 4, and the mechanism control unit 4 controls the amplifier 2 via the interface unit 221. The amplifier 2 is connected to the agitating unit 104 via the connector 201. Further, a relay group 213 is provided between the amplifier 2 and the connector 201. The relay group 213 includes a plurality of switches, and opening and closing of each switch is controlled by a command from the mechanism control unit 4. That is, the relay group 213 functions as a switch device that switches connection between the amplifier 2 and each of the split electrodes 204 and 209.

The mechanism control unit 4 detects a liquid level position (a liquid level height) of liquid in the reaction vessel 114. Further, the mechanism control unit 4 selects one or more split electrodes 204 and 209 at appropriate positions in accordance with the liquid level position, and controls the relay group 213 to apply a voltage to the selected split electrodes 204 and 209. In this way, a position at which the reaction vessel 114 is irradiated with ultrasonic waves is adjusted.

As described above, the mechanism control unit 4 of the present embodiment applies a voltage to each of the split electrodes 204 and 209 via the amplifier 2. When a voltage is applied to each of the split electrodes 204 and 209, the piezoelectric element 202 is driven to generate ultrasonic waves.

Next, a configuration of an electrical circuit of the amplifier 2 will be described. FIG. 3 is a diagram illustrating the electrical circuit of the amplifier, and the agitating unit and the mechanism control unit connected thereto. As illustrated in FIG. 3, the amplifier 2 includes a switching amplifier 16, a transformer 19, a variable reactance impedance matching circuit 11, a voltage detection unit 13, a current detection unit 14, and a calculation unit 12.

The switching amplifier 16 generates a driving frequency Frs of the piezoelectric element 202. The transformer 19 converts output of the switching amplifier 16 according to a turn ratio. Here, the output of the switching amplifier 16 can be increased when a load impedance (an impedance seen from a primary side of the transformer 19 to a secondary side) at the driving frequency Frs is low. On the other hand, the impedance of the piezoelectric element 202 varies depending on a material thereof, and the impedance may be several hundred $\Omega$ at the driving frequency Frs and may be high as a load of the switching amplifier 16. Therefore, in the present embodiment, the variable reactance impedance matching circuit 11 for reducing the impedance on a piezoelectric element 202 side is inserted between the transformer 19 and the piezoelectric element 202.

The voltage detection unit 13 detects a voltage applied to the piezoelectric element 202 and outputs the detected voltage to the calculation unit 12. The current detection unit 14 detects a current flowing through the piezoelectric element 202 and outputs the detected current to the calculation unit 12. The calculation unit 12 calculates effective electrical power based on the detected voltage and the detected current, and determines an adjustment signal using the calculated effective electrical power and a predetermined target electrical power. The variable reactance impedance matching circuit 11 is connected to the secondary side of the transformer 19 and adjusts output electrical power of the amplifier 2 by changing a reactance component based on a reactance adjustment signal 15. Details of the calculation method of the effective electrical power and the adjustment method of the output electrical power will be described later.

Hereinafter, a specific example of the amplifier 2 will be described using Embodiment 1 to Embodiment 7.

Embodiment 1

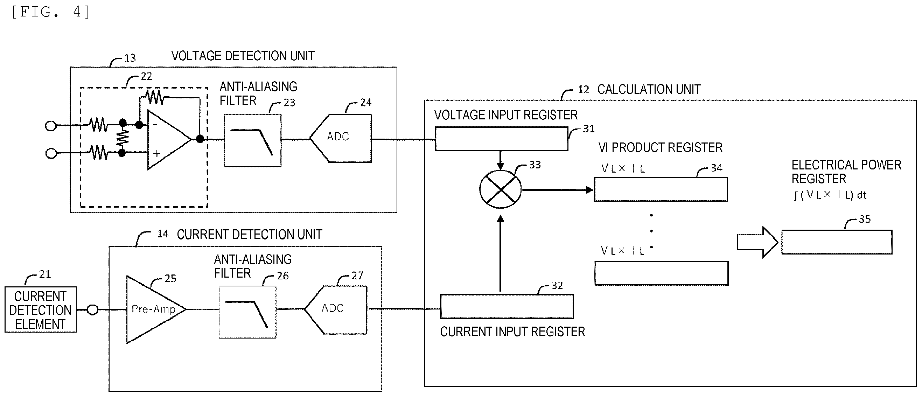

FIG. 4 is a diagram illustrating configurations of a voltage detection unit, a current detection element, a current detection unit, and a calculation unit of an amplifier according to Embodiment 1.

The voltage detection unit 13 includes an input amplifier 22, an anti-aliasing filter 23, and an AD converter 24. The input amplifier 22 linearly amplifies the voltage applied to the piezoelectric element 202 and outputs the voltage to the anti-aliasing filter 23. The anti-aliasing filter 23 has a cutoff frequency equal to or higher than the driving frequency Frs × 2, and removes a frequency band serving as an alias for the AD converter 24. The AD converter 24 AD-converts a voltage signal from which an alias component is removed, and outputs the voltage signal to a voltage input register 31 of the calculation unit 12.

The current detection element 21 is an element that clamps an input cable of the piezoelectric element 202 and detects the current. The current detection unit 14 includes a pre-amplifier 25, an anti-aliasing filter 26, and an AD converter 27. The pre-amplifier 25 converts the current detected by the current detection element 21 into a voltage and outputs the voltage to the anti-aliasing filter 26. The AD converter 27 AD-converts a current signal from which an alias component is removed, and outputs the current signal to a current input register 32 of the calculation unit 12.

The calculation unit 12 includes the voltage input register 31, the current input register 32, a multiplier 33, a VI product register 34, and an electrical power register 35. The voltage input register 31 and the current input register 32 synchronously output data to the multiplier 33, and the multiplier 33 outputs a product of the data to the VI product register 34. The VI product register 34 shifts the product data and outputs a sum Psum of the product data to the electrical power register 35 after a time Ts seconds sufficient for power calculation elapses.

In this way, the calculation unit 12 can calculate effective electrical power Prp = Psum/Ts supplied to the piezoelectric element 202. That is, the effective electrical power Prp is obtained by the following (Formula 1), where V(t) is a piezoelectric element voltage and I(t) is a piezoelectric element current.

$$Prp = [\int\{(V(t) \times I(t)\}dt]/Ts \quad \text{(Formula 1)}$$

The amplifier 2 of the present embodiment performs control such that effective electrical power Prl to be supplied to the piezoelectric element 202 approaches predetermined target electrical power. Here, different values of the target electrical power are stored in a table 51 for each frequency and for each type of the piezoelectric element 202. The table 51 is stored in a storage unit (not illustrated).

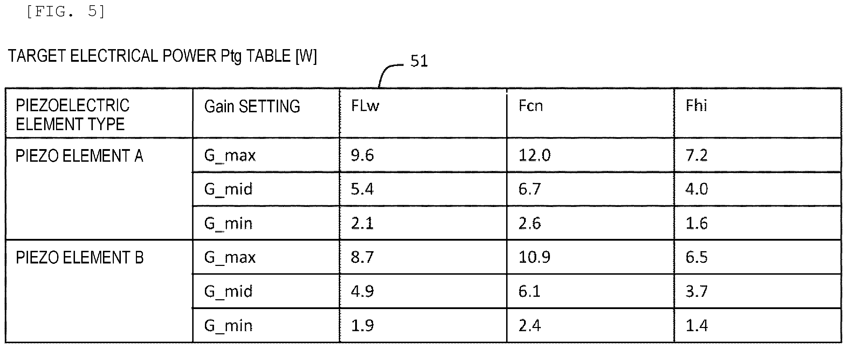

FIG. 5 is an example of a table that stores target electrical power values according to Embodiment 1. The automatic analyzer of the present embodiment can use different types of piezoelectric elements, that is, the amplifier 2 of the present embodiment can drive the piezoelectric elements 202 made of materials with different characteristics. In FIG. 5, for example, a material of a piezo element A is lead zirconate titanate (PZT), and a material of a piezo element B is lithium niobate (LN). A gain of the amplifier 2 can be set to one of three levels: a maximum gain Gmax, a middle gain Gmid, and a minimum gain Gmin. The frequency of the amplifier 2 has a plurality of channels each having a minimum frequency FLw, a center frequency Fcn, and a lowest frequency Fhi, and for example, a 1.0 MHz to 1.5 MHz band is used. For example, when the piezo element A is driven with the middle gain Gmid and the center frequency Fcn, target electrical power Ptg is 6.7 W.

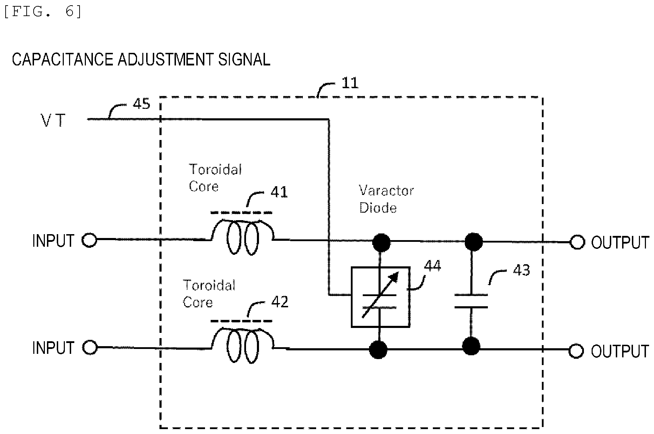

Next, an operation of the variable reactance impedance matching circuit 11 will be described. FIG. 6 is a diagram illustrating a configuration of a variable reactance impedance matching circuit according to Embodiment 1. The variable reactance impedance matching circuit 11 of the present embodiment includes inductors (toroidal cores 41 and 42), a capacitor 43, and a variable capacitance diode (a varactor diode 44). The varactor diode 44 is connected in parallel to the capacitor 43.

The toroidal cores 41 and 42 and the capacitor 43 convert the impedance of the piezoelectric element 202 of several hundred Ω into a low impedance to match the impedance with the switching amplifier 16. When the calculation unit 12 outputs a capacitance adjustment signal 45 in order to bring the effective electrical power close to the target electrical power stored in the table 51, a capacitance value of the varactor diode 44 changes, and thus the impedance seen from the primary side of the transformer 19 changes. In the present embodiment, by utilizing this principle, the impedance change due to deviation of a resonance frequency of the piezoelectric element 202 can be corrected by capacitance adjustment of the varactor diode 44.

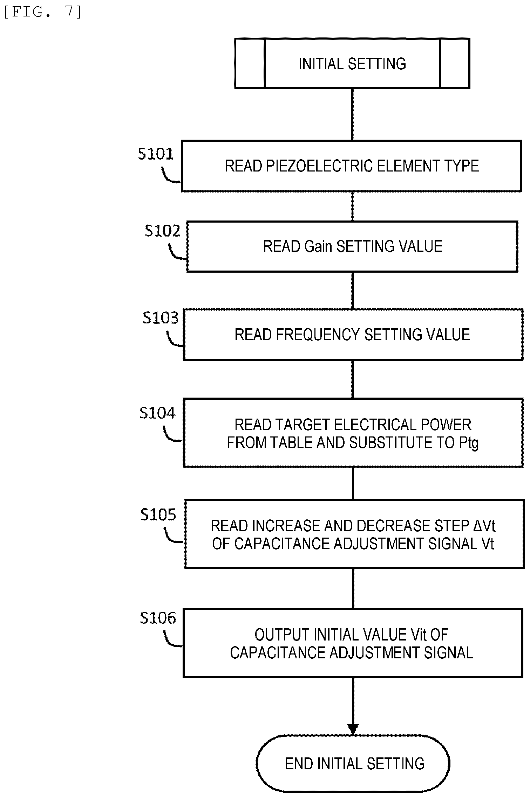

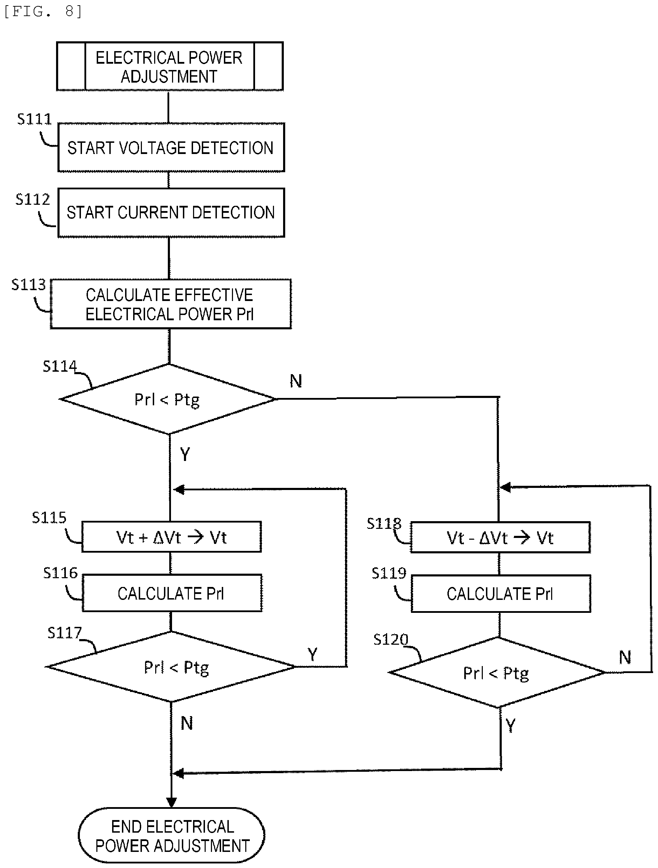

Next, a method for controlling the variable reactance impedance matching circuit 11 by the calculation unit 12 will be described with reference to FIGS. 7 and 8.

First, initial setting will be described. FIG. 7 is a flowchart illustrating a process of the initial setting performed by the calculation unit. When the automatic analyzer is powered on, the calculation unit 12 reads, from the storage unit, information on the type of the piezoelectric element 202 (for example, the piezo element A or the piezo element B) connected to the amplifier 2 (step S101). The calculation unit 12 reads gain setting values (for example, Gmax, Gmid, and Gmin) of the amplifier 2 from the storage unit (step S102). Further, the calculation unit 12 reads frequency setting values (for example, FLw, Fcn, and Fhi) of the amplifier 2 from the storage unit (step S103). Thereafter, the calculation unit 12 refers to the table 51 illustrated in FIG. 5 based on setting information read in step S101 to step S103, and substitutes a corresponding value into the target electrical power Ptg (step S104). For example, when the piezoelectric element type is the piezo element A, the gain setting value is Gmid, and the frequency setting value is Fcn, 6.7 is substituted into the target electrical power Ptg.

Next, the calculation unit 12 reads, from the storage unit, ΔVt which is an increase and decrease step amount when changing the capacitance adjustment signal 45 (Vt) (step S105). The increase and decrease step amount ΔVt is predetermined in the storage unit based on a change amount of the effective electrical power Prl to be supplied to the piezoelectric element 202 when the voltage applied to the varactor diode 44 in the variable reactance impedance matching circuit 11 is changed.

Finally, the calculation unit 12 outputs an initial value Vit of the capacitance adjustment signal 45 (Vt) to the variable reactance impedance matching circuit 11 (step S106), and ends the process of the initial setting. Here, it is desirable that the initial value Vit of the capacitance adjustment signal 45 (Vt) is set to, for example, a median value of an applied voltage range of the varactor diode 44 so as to correspond to the change amount of the effective electrical power Prl to be supplied to the piezoelectric element 202.

Next, electrical power adjustment will be described. FIG. 8 is a flowchart illustrating a process of the electrical power adjustment performed by the calculation unit. First, the calculation unit 12 causes the voltage detection unit 13 to start voltage detection (step S111) and causes the current detection unit 14 to start current detection (step S112).

Thereafter, the calculation unit 12 calculates the effective electrical power Prl by the method described above with reference to FIG. 4 (step S113).

Next, the calculation unit 12 compares the effective electrical power Prl with the target electrical power Ptg (step S114). When the effective electrical power Prl is smaller than the target electrical power Ptg, the calculation unit 12 sets, as a new capacitance adjustment signal, a value obtained by adding the increase and decrease step amount Δt to the current capacitance adjustment signal (step S115). The calculation unit 12 calculates the effective electrical power Prl based on the voltage and the current when the capacitance of the varactor diode 44 is changed by the new capacitance adjustment signal (step S116). Then, the calculation unit 12 compares the effective electrical power Prl with the target electrical power again (step S117). When the effective electrical power Prl is equal to or greater than the target electrical power Ptg, the process of the electrical power adjustment ends. When the effective electrical power Prl is smaller than the target electrical power Ptg, step S115 to step S117 are repeated. It is assumed that there is a relationship between the capacitance adjustment signal and the effective electrical power such that the higher the capacity adjustment signal, the greater the effective electrical power, i.e., a positive correlation.

In step S114 described above, when the effective electrical power Prl is equal to or greater than the target electrical power Ptg, the calculation unit 12 sets, as a new capacitance adjustment signal, a value obtained by subtracting the increase and decrease step amount Δt from the current capacitance adjustment signal (step S118). The calculation unit 12 calculates the effective electrical power Prl based on the voltage and the current when the capacitance of the varactor diode 44 is changed by the new capacitance adjustment signal (step S119). Then, the calculation unit 12 compares the effective electrical power Prl with the target electrical power again (step S120). When the effective electrical power Prl is smaller than the target electrical power Ptg, the process of the electrical power adjustment ends. When the effective electrical power Prl is equal to or larger than the target electrical power Ptg, step S118 to step S120 are repeated.

By the above electrical power adjustment, the effective electrical power Prl can be brought close to the target electrical power Ptg. Accordingly, even when characteristics of the piezoelectric element 202 vary, for example, even when the resonance frequency is shifted with time, desired electrical power can be supplied to the piezoelectric element 202. When stable electrical power is supplied, variations in output sound pressure from the piezoelectric element 202 can be prevented, and as a result, the sample and the reagent can be stably agitated. Further, when the piezoelectric element 202 already installed in the automatic analyzer is changed to a type having different characteristics, for example, even when a material containing lead (for example, PZT) is changed to a material not containing lead (for example, LN), the piezoelectric element 202 can be driven by the same amplifier 2 by performing the above-described electrical power adjustment.

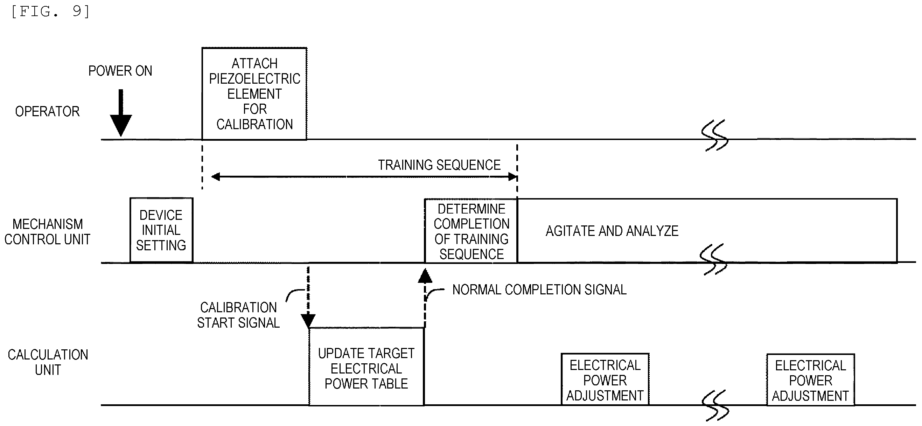

Next, a training sequence of the electrical power adjustment will be described. FIG. 9 is a timing chart illustrating a timing of the training sequence. As illustrated in FIG. 9, when an operator powers on the automatic analyzer, the mechanism control unit 4 performs initialization setting of the entire device. At this time, the initial value Vit of the capacitance adjustment signal 45 (Vt) and an increase and decrease step ΔVt are also set.

Thereafter, the operator attaches the piezoelectric element 202 for electrical power calibration to the automatic analyzer. The piezoelectric element 202 for calibration is an individual having standard characteristics, for example, an individual having a standard resonance frequency without a variation of the piezo element A. The piezoelectric element 202 for electrical power calibration may be attached in advance to a specific position on an outer peripheral side of the reaction disk.

The mechanism control unit 4 starts the training sequence and transmits a calibration start signal to the calculation unit 12. The calculation unit 12 updates the table 51 illustrated in FIG. 5 by calculating each effective electrical power when the gain setting value and the frequency setting value of the amplifier 2 are changed. When the update of the table 51 is completed, the calculation unit 12 transmits a normal completion signal to the mechanism control unit 4. When receiving the normal completion signal 206, the mechanism control unit 4 determines the end of the training sequence, and starts an analysis operation including agitating of a sample and a reagent.

As described above, by updating the table of the target electrical power at the timing of calibration of the automatic analyzer, which is performed after power-on and before starting analysis, the power adjustment can be normally performed thereafter. The piezoelectric element 202 attached for calibration may be used for actual agitating as it is.

Embodiment 2

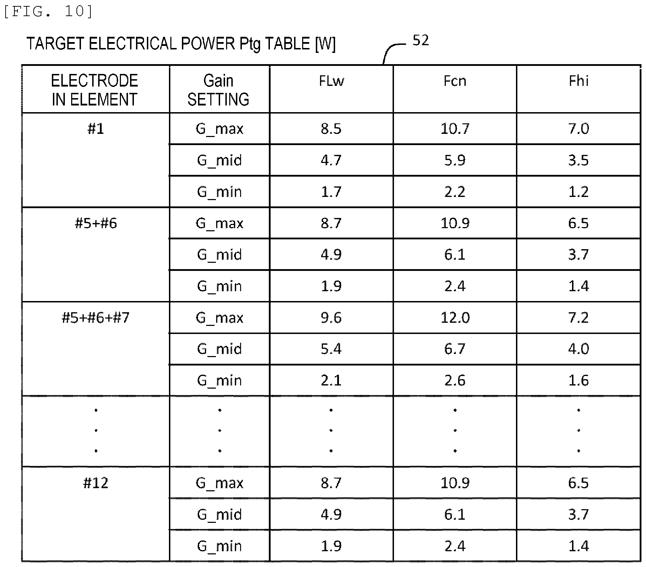

FIG. 10 is an example of a table that stores target electrical power values according to Embodiment 2. In an automatic analyzer according to the embodiment of the invention, as described above, an electrode of the piezoelectric element 202 includes a plurality of (#1 to #12) split electrodes 204. Here, characteristics of voltage and current may be different for each split electrode 204. Therefore, in the present embodiment, different values of the target electrical power Ptg are stored in a table 52 for each split electrode 204. When voltages are simultaneously applied to the plurality of split electrodes 204, different values of the target electrical power Ptg are stored in the table 52 for each combination. For example, when the split electrodes 204 of #5 and #6 are connected in parallel, a gain setting value is a middle gain Gmid, and a frequency setting value is a center frequency Fcn, the target electrical power Ptg is 6.1 W. According to the present embodiment, even when the piezoelectric element 202 includes a plurality of electrodes, electrical power to be supplied to each electrode can be stabilized by approaching the target electrical power set according to each electrode and the combination thereof, and a variation in output sound pressure can be prevented.

Embodiment 3

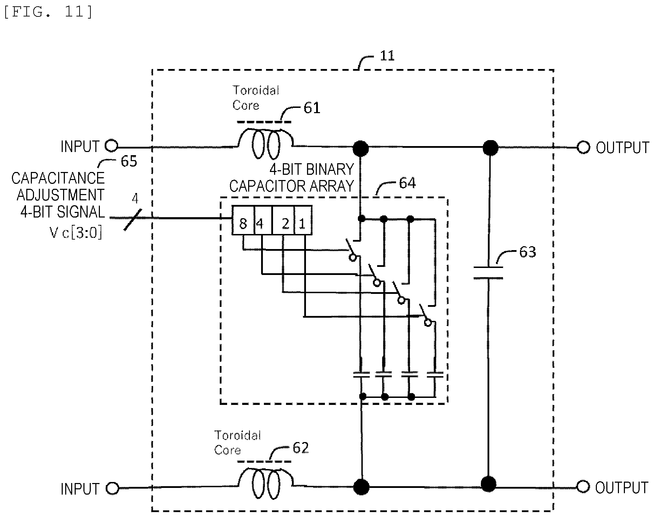

FIG. 11 is a diagram illustrating a configuration of a variable reactance impedance matching circuit according to Embodiment 3. The variable reactance impedance matching circuit 11 of the present embodiment includes inductors (toroidal cores 61 and 62), a capacitor 63, and a 4-bit binary capacitor array 64. The 4-bit binary capacitor array 64 is an element that is connected in parallel to the capacitor 63, and in which 8421 weighted capacitors are turned on and off based on a capacitance adjustment 4-bit signal 65, thereby changing a capacitance between terminals.

In the present embodiment, as in the case of the configuration illustrated in FIG. 6 in Embodiment 1, the toroidal cores 61 and 62 and the capacitor 63 convert an impedance of the piezoelectric element 202 of several hundred Ω into a low impedance to match an impedance with the switching amplifier 16. In the present embodiment, in order to bring effective electrical power close to the target electrical power Ptg, when the calculation unit 12 outputs the capacitance adjustment 4-bit signal 65 and one of a plurality capacitors constituting the 4-bit binary capacitor array 64 is changed to be turned ON, a capacitance value changes, and thus an impedance seen from a primary side of the transformer 19 also changes. In the present embodiment, by utilizing this principle, the impedance change due to deviation of a resonance frequency of the piezoelectric element 202 can be digitally corrected by the capacitance adjustment of the 4-bit binary capacitor array 64.

Embodiment 4

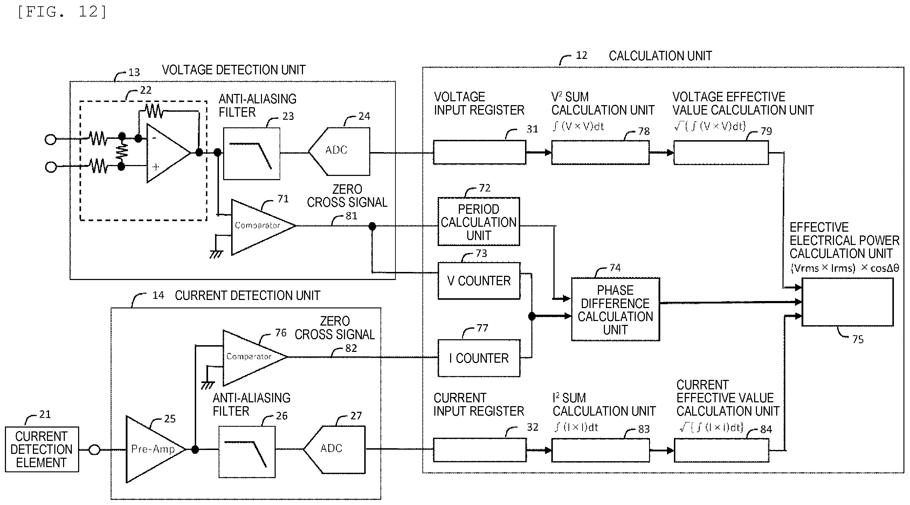

FIG. 12 is a diagram illustrating configurations of a voltage detection unit, a current detection element, a current detection unit, and a calculation unit in an amplifier according to Embodiment 4. Hereinafter, only differences from the configuration illustrated in FIG. 4 in Embodiment 1 will be described.

The voltage detection unit 13 of the present embodiment further includes a voltage zero cross detector 71 (a comparator) in addition to the input amplifier 22, the anti-aliasing filter 23, and the AD converter 24. The current detection unit 14 of the present embodiment further includes a current zero cross detector 76 (a comparator) in addition to the pre-amplifier 25, the anti-aliasing filter 26, and the AD converter 27. The calculation unit 12 of the present embodiment includes the voltage input register 31, a $V^2$ sum calculation unit 78, a voltage effective value calculation unit 79, the current input register 32, an $I^2$ sum calculation unit 83, a current effective value calculation unit 84, a period calculation unit 72, a V counter 73, an I counter 77, a phase difference calculation unit 74, and an effective electrical power calculation unit 75.

When the AD converter 24 of the voltage detection unit 13 outputs a voltage AD conversion value to the voltage input register 31, the $V^2$ sum calculation unit 78 squares and sequentially adds the voltage AD conversion value to calculate a sum of $V^2$. The voltage effective value calculation unit 79 calculates a square root of the sum of $V^2$, and outputs a calculation result thereof as a voltage effective value Vrms to the effective electrical power calculation unit 75. The voltage zero cross detector 71 detects an intersection point of output of the input amplifier 22 with 0 volt, and outputs a voltage zero cross signal 81 to the period calculation unit 72 and the V counter 73. The period calculation unit 72 calculates one period of a voltage signal from the voltage zero cross signal 81.

On the other hand, when the AD converter 27 of the current detection unit 14 outputs a current AD conversion value to the current input register 32, the $I^2$ sum calculation unit 83 squares and sequentially adds the current AD conversion value to calculate a sum of $I^2$. The current effective value calculation unit 84 calculates a square root of the sum of $I^2$, and outputs a calculation result thereof as a current effective value Irms to the effective electrical power calculation unit 75. The current zero cross detector 76 detects an intersection point of output of the pre-amplifier 25 with 0 volt, and outputs a current zero cross signal 82 to the I counter 77.

The phase difference calculation unit 74 of the calculation unit 12 is synchronized with the period calculation unit 72, the V counter 73, and the I counter 77, obtains a phase difference time $\Delta T$ from a count value of the V counter 73 and a count value of the I counter 77, and obtains a phase difference $\Delta\theta$ by the following formula using one period T output from the period calculation unit 72.

$$\text{Phase difference } \Delta\theta = \Delta T/T \text{ (Formula 2)}$$

The effective electrical power calculation unit 75 of the calculation unit 12 calculates the effective electrical power Prl based on the output Vrms of the voltage effective value calculation unit 79, the output Irms of the current effective value calculation unit 84, and the output $\Delta\theta$ of the phase difference calculation unit 74 by the following Formula.

$$\text{Effective electrical power Prl} = (\text{Vrms} \times \text{Irms}) \times \cos\Delta\theta \text{ (Formula 3)}$$

In this way, the effective electrical power Prl supplied to the piezoelectric element 202 can be calculated based on the voltage applied to the piezoelectric element 202 and the current flowing therethrough.

Embodiment 5

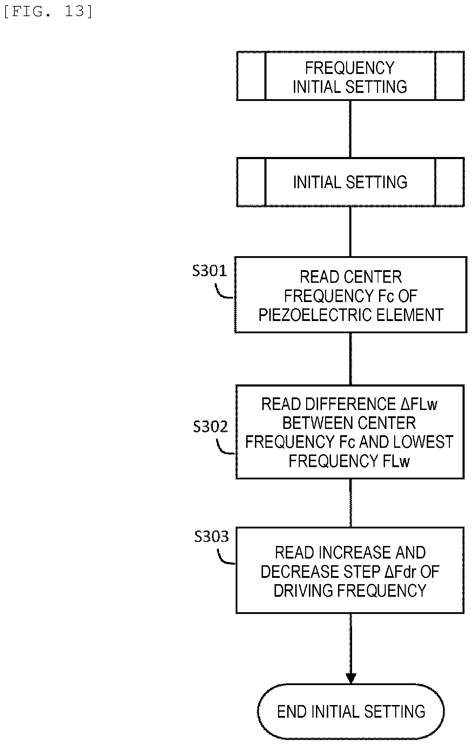

Embodiment 5 will be described with reference to FIGS. 13 to 15. In Embodiment 1, only the electrical power adjustment as described with reference to FIGS. 7 and 8 is performed, but in the present embodiment, not only the electrical power adjustment but also adjustment of the driving frequency Fdr for driving the piezoelectric element 202, that is, frequency search electrical power adjustment is performed.

FIG. 13 is a flowchart illustrating a process of initial setting of the frequency search electrical power adjustment performed by the calculation unit. When the automatic analyzer is powered on, the calculation unit 12 first performs the same process as the initial setting illustrated in FIG. 7 in Embodiment 1. Next, the calculation unit 12 reads a center frequency Fc of the piezoelectric element (which may be a nominal driving frequency of the piezoelectric element) from the storage unit (step S301). The calculation unit 12 reads, from the storage unit, a difference $\Delta$FLw between the center frequency Fc and the lowest frequency FLw at which the amplifier 2 can drive the piezoelectric element (step S302). Further, the calculation unit 12 reads, from the storage unit, a frequency increase and decrease step $\Delta$Fdr for increasing or decreasing the driving frequency Fdr (step S303). The center frequency Fc, the lowest frequency FLw, the center frequency Fc, the frequency increase and decrease step $\Delta$Fdr, and the like are predetermined in the storage unit for each type of piezoelectric element, for example.

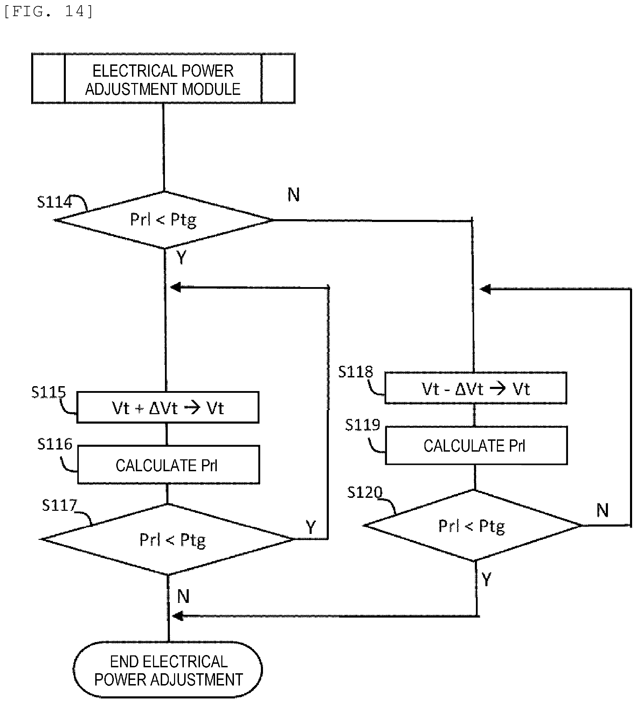

FIG. 14 is a diagram illustrating an electrical power adjustment module used in the frequency search electrical power adjustment. The electrical power adjustment module illustrated in FIG. 14 corresponds to a portion after step S114 in the process of the electrical power adjustment illustrated in FIG. 8 in Embodiment 1.

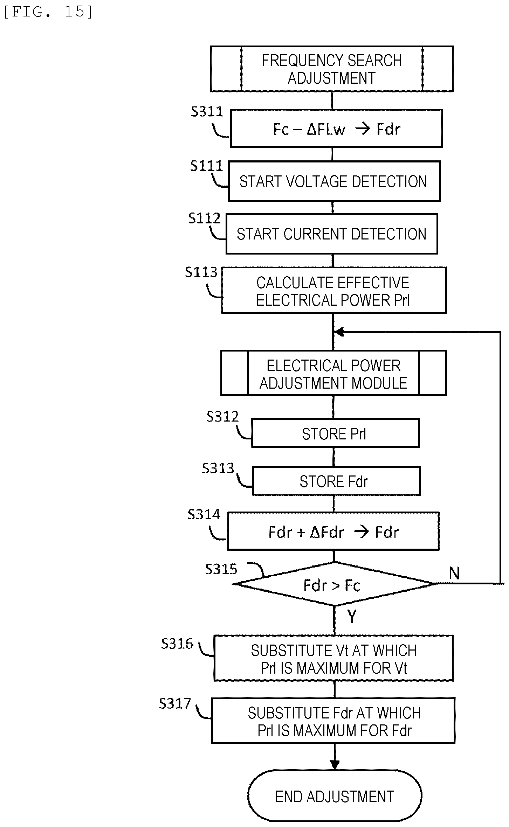

FIG. 15 is a flowchart illustrating a process of the frequency search electrical power adjustment performed by the calculation unit. First, the calculation unit 12 substitutes a center frequency Fc - $\Delta$FLw as the driving frequency Fdr (step S311).

Next, similar to the process of the electrical power adjustment illustrated in FIG. 8 in Embodiment 1, the calculation unit 12 performs the process of electrical power adjustment module illustrated in FIG. 14 after performing step S111 to step S113.

The calculation unit 12 stores, in the storage unit, the effective electrical power Prl after adjustment in the electrical power adjustment module (step S312) and stores the current driving frequency Fdr in the storage unit (step S313). Thereafter, the calculation unit 12 sets, as a new driving frequency Fdr, a value obtained by adding the frequency increase and decrease step $\Delta$Fdr to the current driving frequency Fdr (step S314) and compares the new driving frequency Fdr with the center frequency Fc (step S315).

When the driving frequency Fdr is equal to or lower than the center frequency Fc, the process returns to the process of the electrical power adjustment module illustrated in FIG. 14, and step S312 to step S315 are repeated. When the driving frequency Fdr is higher than the center frequency Fc, the calculation unit 12 sets, as a reactance adjustment voltage after frequency search adjustment, a reactance adjustment voltage (a capacitance adjustment signal) when the effective electrical power stored in the storage unit is maximum (step S316), and sets the driving frequency at that time as the driving frequency after the frequency search adjustment (step S317).

As described above, when the driving frequency for driving the piezoelectric element is changed stepwise in a certain range and the effective electrical power is sequentially calculated, the frequency at which the effective electrical power is maximum is found. When the piezoelectric element is driven at this frequency, output sound pressure can be increased.

Characteristics of the piezoelectric element include a resonance frequency at which an impedance is at a minimum, and an anti-resonance frequency in a higher frequency range at which the impedance is at a maximum. Therefore, when a search is performed while increasing the frequency stepwise from a low frequency as in the present embodiment, there is an advantage that the resonance frequency can be easily found. When the piezoelectric element is driven at the resonance frequency, a displacement of the piezoelectric element is maximum, and strong ultrasonic waves can be efficiently generated.

Embodiment 6

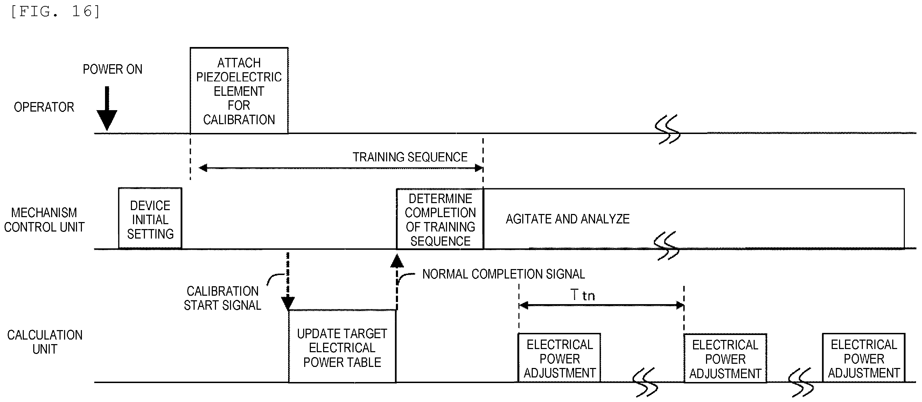

Embodiment 6 will be described with reference to FIG. 16. FIG. 16 is a timing chart illustrating a timing of the electrical power adjustment. A process from when an operator powers on the automatic analyzer to when the training sequence is executed to start the analysis operation is as described above with reference to FIG. 9 in Embodiment 1.

In the present embodiment, the amplifier 2 adjusts output electrical power every time a predetermined time elapses. Specifically, after the calculation unit 12 determines a capacitance adjustment signal, the electrical power adjustment is not performed until a time Ttn elapses. Accordingly, unnecessary electrical power adjustment can be omitted. The time Ttn is determined in consideration of a time during which deterioration over time may occur in the piezoelectric element (for example, one month). The timing of the electrical power adjustment may be determined based on whether a predetermined number of samples (for example, 100000 samples) reaches, instead of whether a predetermined time elapses.

Embodiment 7

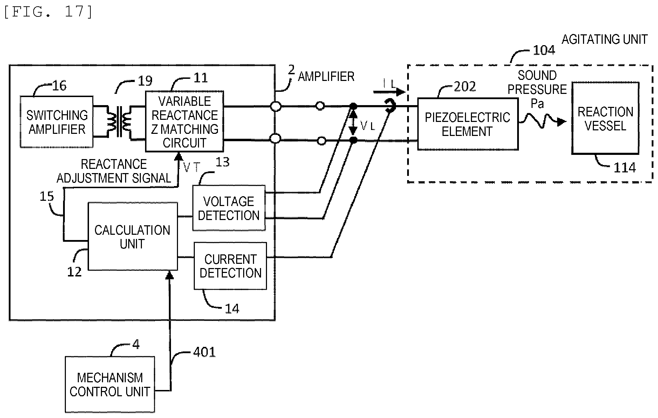

Embodiment 7 will be described with reference to FIG. 17. FIG. 17 is a diagram illustrating a signal transmitted from the mechanism control unit to the amplifier.

As described above, the reaction vessel 114 containing the sample and the reagent sequentially moves to a front surface of the agitating unit 104 by repeating rotation and stop of a reaction disk. Here, when the piezoelectric element is driven to generate ultrasonic waves before the agitating unit 104, that is, at a timing when the reaction vessel 114 accommodating a sample or the like is not present at an agitating position, the piezoelectric element may be damaged due to an influence of reflection. Therefore, in the present embodiment, when the reaction disk is at a predetermined rotational position and the reaction vessel 114 is at the agitating position, the mechanism control unit 4 transmits a reaction vessel facing signal 401 to the calculation unit 12 of the amplifier 2. Then, the calculation unit 12 performs electrical power adjustment only when the reaction vessel facing signal 401 is received from the mechanism control unit 4. When a reactance adjustment signal is determined, the calculation unit 12 ends the electrical power adjustment.

The signal transmitted from the mechanism control unit 4 to the amplifier 2 may include information indicating whether analysis is being performed. The calculation unit 12 may perform the electrical power adjustment only when the automatic analyzer is performing analysis. This is because the electrical power adjustment is useless when the automatic analyzer is not performing analysis.

The invention is not limited to the embodiments described above, and includes various modifications. For example, the embodiments described above have been described in detail to facilitate understanding of the invention, and the invention is not necessarily limited to those including all the configurations described above. A part of a configuration in one embodiment can be replaced with a configuration in another embodiment, and a configuration in one embodiment can also be added to a configuration in another embodiment. A part of a configuration in each embodiment may be added to, deleted from, or replaced with another configuration.

**Reference Signs List**

2: amplifier
4: mechanism control unit
11: variable reactance impedance matching circuit
12: calculation unit
13: voltage detection unit
14: current detection unit
15: reactance adjustment signal
16: switching amplifier

19: transformer

21: current detection element

22: input amplifier

23, 26: anti-aliasing filter

24, 27: AD converter

25: pre-amplifier

31: voltage input register

32: current input register

33: multiplier

34: VI product register

35: electrical power register

41, 42, 61, 62: toroidal core

43, 63: capacitor

44: varactor diode

45: capacitance adjustment signal

64: 4-bit binary capacitor array

65: capacitance adjustment 4-bit signal

71: voltage zero cross detector

72: period calculation unit

73: V counter

74: phase difference calculation unit

75: effective electrical power calculation unit

76: current zero cross detector

77: I counter

78: $V^2$ sum calculation unit

79: voltage effective value calculation unit

81: voltage zero cross signal

82: current zero cross signal

83: $I^2$ sum calculation unit

84: current effective value calculation unit

51, 52: table

101: sample storage unit

102: reagent storage unit

103: reaction unit

104 to 109: agitating unit

110: analysis unit

111: washing unit

112: sample

113: sample aliquoting mechanism

114: reaction vessel

115: reagent aliquoting mechanism

116: reagent

117: constant temperature bath

201: connector

202: piezoelectric element

203: jig

204: split electrode

205: constant temperature water side electrode

208: constant temperature water

209: split electrode (on lower side)

213: relay group

223: reflection plate

221: interface unit

401: reaction vessel facing signal

**Claims**

1. An automatic analyzer for agitating a sample and a reagent by using ultrasonic waves generated by driving a piezoelectric element, wherein
an amplifier configured to drive the piezoelectric element includes

> a voltage detection unit configured to detect a voltage applied to the piezoelectric element,
> a current detection unit configured to detect a current flowing through the piezoelectric element,
> a calculation unit configured to calculate effective electrical power based on a detected voltage detected by the voltage detection unit and a detected current detected by the current detection unit and determine an adjustment signal using the calculated effective electrical power and a predetermined target electrical power, and
> an impedance matching circuit configured to adjust output electrical power of the amplifier by changing a reactance component based on the adjustment signal determined by the calculation unit.

2. The automatic analyzer according to claim 1, wherein
different values of the target electrical power are stored in a table for each frequency.

3. The automatic analyzer according to claim 2, wherein
different values of the target electrical power are stored in the table for each type of the piezoelectric element.

4. The automatic analyzer according to claim 3, wherein
the type of the piezoelectric element includes a PZT element and an LN element.

5. The automatic analyzer according to claim 2, wherein
after power-on and before starting analysis, the table is updated by the calculation unit calculating each effective electrical power of the amplifier when a gain setting value and a frequency setting value of the amplifier are changed.

6. The automatic analyzer according to claim 1, wherein
the impedance matching circuit includes a variable capacitance diode and an inductor.

7. The automatic analyzer according to claim 1, wherein
the calculation unit calculates the effective electrical power based on a sum of products of a value obtained by AD-converting the detected voltage and a value obtained by AD-converting the detected current.

8. The automatic analyzer according to claim 2, wherein

> the piezoelectric element has a plurality of electrodes at different height positions, and
> different values of the target electrical power are stored in the table for each of the electrodes or each combination thereof.

9. The automatic analyzer according to claim 1, wherein
the impedance matching circuit includes an inductor and a capacitor array in which each capacitor can be selectively turned on or off.

10. The automatic analyzer according to claim 1, wherein
the calculation unit calculates the effective electrical power based on a voltage effective value calculated from a value obtained by AD-converting the detected voltage, a current effective value calculated from a value obtained by AD-converting the detected current, and a phase difference calculated from the detected voltage and the detected current.

11. The automatic analyzer according to claim 1, wherein
the calculation unit changes a driving frequency for driving the piezoelectric element, and determines the adjustment signal and the driving frequency using the effective electrical power calculated for each driving frequency.

12. The automatic analyzer according to claim 11, wherein
the driving frequency changed by the calculation unit is in a range from a nominal driving frequency or a center frequency of the piezoelectric element to a lowest frequency at which the piezoelectric element is drivable.

13. The automatic analyzer according to claim 12, wherein

the calculation unit increases the driving frequency stepwise from the lowest frequency when changing the driving frequency.

14. The automatic analyzer according to claim 1, wherein
the amplifier adjusts the output electrical power each time a predetermined time elapses.

15. The automatic analyzer according to claim 1, further comprising:

a mechanism control unit configured to control a rotatable reaction disk on which a reaction vessel containing a sample and a reagent is provided, wherein
the amplifier adjusts the output electrical power when the amplifier receives from the mechanism control unit that the reaction vessel is at an agitating position or that analysis is being performed.

[FIG. 1]

EP 4 513 194 A1

[FIG. 2]

[FIG. 3]

[FIG. 4]

VOLTAGE DETECTION UNIT

13

22

ANTI-ALIASING FILTER

23

24

ADC

12 CALCULATION UNIT

VOLTAGE INPUT REGISTER

31

VI PRODUCT REGISTER

33

$V_L \times I_L$

34

ELECTRICAL POWER REGISTER

$\int (V_L \times I_L)\, dt$

$V_L \times I_L$

35

14 CURRENT DETECTION UNIT

ANTI-ALIASING FILTER

25

26

27

21

CURRENT DETECTION ELEMENT

Pre-Amp

ADC

32

CURRENT INPUT REGISTER

EP 4 513 194 A1

[FIG. 5]

TARGET ELECTRICAL POWER Ptg TABLE [W] — 51

| PIEZOELECTRIC ELEMENT TYPE | Gain SETTING | FLw | Fcn | Fhi |
|---|---|---|---|---|
| PIEZO ELEMENT A | G_max | 9.6 | 12.0 | 7.2 |
| | G_mid | 5.4 | 6.7 | 4.0 |
| | G_min | 2.1 | 2.6 | 1.6 |
| PIEZO ELEMENT B | G_max | 8.7 | 10.9 | 6.5 |
| | G_mid | 4.9 | 6.1 | 3.7 |
| | G_min | 1.9 | 2.4 | 1.4 |

EP 4 513 194 A1

[FIG. 6]

CAPACITANCE ADJUSTMENT SIGNAL

[FIG. 7]

```
                    ┌──┬─────────────────────┬──┐
                    │  │   INITIAL SETTING   │  │
                    └──┴─────────────────────┴──┘
                                  │
         S101      ┌──────────────────────────────────┐
                   │   READ PIEZOELECTRIC ELEMENT TYPE │
                   └──────────────────────────────────┘
                                  │
         S102      ┌──────────────────────────────────┐
                   │      READ Gain SETTING VALUE      │
                   └──────────────────────────────────┘
                                  │
         S103      ┌──────────────────────────────────┐
                   │   READ FREQUENCY SETTING VALUE    │
                   └──────────────────────────────────┘
                                  │
         S104      ┌──────────────────────────────────┐
                   │   READ TARGET ELECTRICAL POWER    │
                   │  FROM TABLE AND SUBSTITUTE TO Ptg  │
                   └──────────────────────────────────┘
                                  │
         S105      ┌──────────────────────────────────┐
                   │ READ INCREASE AND DECREASE STEP ΔVt│
                   │ OF CAPACITANCE ADJUSTMENT SIGNAL Vt│
                   └──────────────────────────────────┘
                                  │
         S106      ┌──────────────────────────────────┐
                   │      OUTPUT INITIAL VALUE Vit OF   │
                   │   CAPACITANCE ADJUSTMENT SIGNAL    │
                   └──────────────────────────────────┘
                                  │
                                  ▼
                        ╭──────────────────────╮
                        │   END INITIAL SETTING │
                        ╰──────────────────────╯
```

[FIG. 8]

```
          ┌──────────────────────────────┐
          │     ELECTRICAL POWER         │
          │       ADJUSTMENT             │
          └──────────────┬───────────────┘
                         │
   S111   ┌──────────────────────────────┐
          │    START VOLTAGE DETECTION    │
          └──────────────┬───────────────┘
                         │
   S112   ┌──────────────────────────────┐
          │    START CURRENT DETECTION    │
          └──────────────┬───────────────┘
                         │
   S113   ┌──────────────────────────────┐
          │    CALCULATE EFFECTIVE        │
          │    ELECTRICAL POWER Prl       │
          └──────────────┬───────────────┘
                         │
   S114         ◇ Prl < Ptg ◇───────────── N ──────────────┐
                         │                                  │
                         Y                                  │
          ┌──────────────▼──────┐              ┌────────────▼───────┐
   S115   │   Vt + ΔVt → Vt     │      S118    │   Vt - ΔVt → Vt    │
          └──────────────┬──────┘              └────────────┬───────┘
   S116   ┌──────────────▼──────┐      S119    ┌────────────▼───────┐
          │   CALCULATE Prl     │              │   CALCULATE Prl    │
          └──────────────┬──────┘              └────────────┬───────┘
                         │                                  │
   S117      ◇ Prl < Ptg ◇── Y ──┐          S120   ◇ Prl < Ptg ◇── N ──┐
                         │                                  │
                         N                                  Y
                         │                                  │
          ┌──────────────▼───────────────┐
          │    END ELECTRICAL            │
          │    POWER ADJUSTMENT          │
          └──────────────────────────────┘
```

[FIG. 9]

EP 4 513 194 A1

[FIG. 10]

TARGET ELECTRICAL POWER Ptg TABLE [W]  — 52

| ELECTRODE IN ELEMENT | Gain SETTING | FLw | Fcn | Fhi |
|---|---|---|---|---|
| #1 | G_max | 8.5 | 10.7 | 7.0 |
| | G_mid | 4.7 | 5.9 | 3.5 |
| | G_min | 1.7 | 2.2 | 1.2 |
| #5+#6 | G_max | 8.7 | 10.9 | 6.5 |
| | G_mid | 4.9 | 6.1 | 3.7 |
| | G_min | 1.9 | 2.4 | 1.4 |
| #5+#6+#7 | G_max | 9.6 | 12.0 | 7.2 |
| | G_mid | 5.4 | 6.7 | 4.0 |
| | G_min | 2.1 | 2.6 | 1.6 |
| · · · | · · · | · · · | · · · | · · · |
| #12 | G_max | 8.7 | 10.9 | 6.5 |
| | G_mid | 4.9 | 6.1 | 3.7 |
| | G_min | 1.9 | 2.4 | 1.4 |

[FIG. 11]

[FIG. 12]

VOLTAGE DETECTION UNIT — 13

22

ANTI-ALIASING FILTER — 23

ADC — 24

Comparator — 71

ZERO CROSS SIGNAL

81

CURRENT DETECTION UNIT — 14

CURRENT DETECTION ELEMENT — 21

Pre-Amp — 25

Comparator — 76

ZERO CROSS SIGNAL

82

ANTI-ALIASING FILTER — 26

ADC — 27

CALCULATION UNIT — 12

VOLTAGE INPUT REGISTER — 31

$V^2$ SUM CALCULATION UNIT $\int (V \times V)dt$ — 78

VOLTAGE EFFECTIVE VALUE CALCULATION UNIT $\sqrt{\{\int (V \times V)dt\}}$ — 79

PERIOD CALCULATION UNIT — 72

V COUNTER — 73

I COUNTER — 77

PHASE DIFFERENCE CALCULATION UNIT — 74

EFFECTIVE ELECTRICAL POWER CALCULATION UNIT $(Vrms \times Irms) \times \cos\Delta\theta$ — 75

CURRENT INPUT REGISTER — 32

$I^2$ SUM CALCULATION UNIT $\int (I \times I)dt$ — 83

CURRENT EFFECTIVE VALUE CALCULATION UNIT $\sqrt{\{\int (I \times I)dt\}}$ — 84

EP 4 513 194 A1

[FIG. 13]

```
┌─────────────────────────────┐
│    FREQUENCY                │
│    INITIAL SETTING          │
└─────────────────────────────┘
              │
┌─────────────────────────────┐
│      INITIAL SETTING        │
└─────────────────────────────┘
              │
S301  ┌─────────────────────────────┐
      │    READ CENTER              │
      │    FREQUENCY Fc OF          │
      │    PIEZOELECTRIC ELEMENT    │
      └─────────────────────────────┘
              │
      ┌─────────────────────────────┐
      │  READ DIFFERENCE ΔFLw       │
S302  │  BETWEEN CENTER             │
      │  FREQUENCY Fc AND LOWEST    │
      │  FREQUENCY FLw              │
      └─────────────────────────────┘
              │
S303  ┌─────────────────────────────┐
      │   READ INCREASE AND         │
      │   DECREASE STEP ΔFdr OF     │
      │   DRIVING FREQUENCY         │
      └─────────────────────────────┘
              │
              ▼
      ╭─────────────────────────────╮
      │    END INITIAL SETTING      │
      ╰─────────────────────────────╯
```

[FIG. 14]

```
            ┌──┬──────────────────────┬──┐
            │  │  ELECTRICAL POWER    │  │
            │  │  ADJUSTMENT MODULE   │  │
            └──┴──────────────────────┴──┘
                          │
                          │
           S114          ╱╲            N
              ╲     ╱────────────╲──────────────────────────┐
               ╲──╱   Prl < Ptg   ╲                         │
                  ╲               ╱                          │
                   ╲────────────╱                           │
                          │ Y                                │
             ┌────────────┘          ┌──────────────────────┤
             │                        │                      │
             ↓                        │                      │
   S115  ┌──────────────────┐   S118 │  ┌──────────────────┐│
      ╲  │  Vt + ΔVt → Vt   │      ╲ │  │  Vt - ΔVt → Vt   ││
         └──────────────────┘        │  └──────────────────┘│
                │                     │           │          │
   S116  ┌──────────────────┐   S119 │  ┌──────────────────┐│
    ╲    │  CALCULATE Prl   │    ╲   │  │  CALCULATE Prl   ││
         └──────────────────┘        │  └──────────────────┘│
                │                     │           │          │
   S117        ╱╲          Y   S120  │          ╱╲        N  │
      ╲    ╱────────╲──────┘    ╲    │      ╱────────╲──────┘
       ╲──╱ Prl < Ptg╲              ╲──╱ Prl < Ptg  ╲
          ╲          ╱                  ╲           ╱
           ╲────────╱                    ╲─────────╱
                │ N                           │ Y
                │←───────────────────────────┘
                ↓
         ┌─────────────────┐
         │  END ELECTRICAL │
         │ POWER ADJUSTMENT│
         └─────────────────┘
```

[FIG. 15]

```
                    ┌──┬─────────────────────┬──┐
                    │  │  FREQUENCY SEARCH   │  │
                    │  │     ADJUSTMENT      │  │
                    └──┴─────────────────────┴──┘
                                │
      S311        ┌─────────────────────────────┐
        └─────────│   Fc − ΔFLw  →  Fdr         │
                  └─────────────────────────────┘
                                │
      S111        ┌─────────────────────────────┐
        └─────────│   START VOLTAGE DETECTION    │
                  └─────────────────────────────┘
                                │
      S112        ┌─────────────────────────────┐
        └─────────│   START CURRENT DETECTION    │
                  └─────────────────────────────┘
                                │
      S113        ┌─────────────────────────────┐
        └─────────│   CALCULATE EFFECTIVE        │
                  │   ELECTRICAL POWER Prl       │
                  └─────────────────────────────┘
                                │
                                ▼ ◄──────────────────┐
                  ┌──┬─────────────────────┬──┐      │
                  │  │  ELECTRICAL POWER    │  │      │
                  │  │ ADJUSTMENT MODULE    │  │      │
                  └──┴─────────────────────┴──┘      │
                                │                      │
      S312        ┌─────────────────────────────┐    │
        └─────────│         STORE Prl           │    │
                  └─────────────────────────────┘    │
                                │                      │
      S313        ┌─────────────────────────────┐    │
        └─────────│         STORE Fdr           │    │
                  └─────────────────────────────┘    │
                                │                      │
      S314        ┌─────────────────────────────┐    │
        └─────────│   Fdr + ΔFdr  →  Fdr        │    │
                  └─────────────────────────────┘    │
                                │                      │
      S315            ◇─────────────────────◇      N  │
            ────────< │     Fdr > Fc          │ >──────┘
                      ◇─────────────────────◇
                                │ Y
      S316        ┌─────────────────────────────┐
        └─────────│   SUBSTITUTE Vt AT WHICH     │
                  │   Prl IS MAXIMUM FOR Vt      │
                  └─────────────────────────────┘
                                │
      S317        ┌─────────────────────────────┐
        └─────────│   SUBSTITUTE Fdr AT WHICH    │
                  │   Prl IS MAXIMUM FOR Fdr     │
                  └─────────────────────────────┘
                                │
                                ▼
                       ╭─────────────────╮
                       │  END ADJUSTMENT  │
                       ╰─────────────────╯
```

[FIG. 16]

EP 4 513 194 A1

[FIG. 17]

<table>
<tr><td colspan="2" align="center">**INTERNATIONAL SEARCH REPORT**</td><td>International application No.<br><br>**PCT/JP2023/010365**</td></tr>
</table>

**A. CLASSIFICATION OF SUBJECT MATTER**

***G01N 35/02***(2006.01)i
FI:  G01N35/02 D

According to International Patent Classification (IPC) or to both national classification and IPC

**B. FIELDS SEARCHED**

Minimum documentation searched (classification system followed by classification symbols)

G01N35/02

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2003-254979 A (HITACHI HIGH-TECHNOLOGIES CORP.) 10 September 2003 (2003-09-10) | 1-15 |
| A | JP 2007-108061 A (OLYMPUS CORP.) 26 April 2007 (2007-04-26) | 1-15 |
| A | JP 2020-003378 A (HITACHI HIGH-TECHNOLOGIES CORP.) 09 January 2020 (2020-01-09) | 1-15 |
| A | JP 2010-217048 A (BECKMAN COULTER, INC.) 30 September 2010 (2010-09-30) | 1-15 |
| A | JP 2010-515913 A (BRUNEL UNIV.) 13 May 2010 (2010-05-13) | 1-15 |
| A | US 2002/0009015 A1 (LAUGHARN, James A.) 24 January 2002 (2002-01-24) | 1-15 |

☐ Further documents are listed in the continuation of Box C.      ☑ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **11 April 2023** | **25 April 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

INTERNATIONAL SEARCH REPORT
Information on patent family members

| Patent document cited in search report | | | Publication date (day/month/year) | Patent family member(s) | | | Publication date (day/month/year) |
|---|---|---|---|---|---|---|---|
| JP | 2003-254979 | A | 10 September 2003 | (Family: none) | | | |
| JP | 2007-108061 | A | 26 April 2007 | US | 2008/0240992 | A1 | |
| | | | | WO | 2007/043261 | A1 | |
| | | | | EP | 1947462 | A1 | |
| JP | 2020-003378 | A | 09 January 2020 | US | 2021/0270707 | A1 | |
| | | | | WO | 2020/003769 | A1 | |
| | | | | EP | 3816631 | A1 | |
| | | | | CN | 112041685 | A | |
| JP | 2010-217048 | A | 30 September 2010 | WO | 2010/106998 | A1 | |
| JP | 2010-515913 | A | 13 May 2010 | US | 2010/0216126 | A1 | |
| | | | | GB | 2446204 | A | |
| | | | | WO | 2008/084245 | A2 | |
| | | | | KR | 10-2009-0104102 | A | |
| | | | | CN | 101631616 | A | |
| US | 2002/0009015 | A1 | 24 January 2002 | WO | 2000/025125 | A1 | |
| | | | | EP | 1875960 | A2 | |

Form PCT/ISA/210 (patent family annex) (January 2015)

**REFERENCES CITED IN THE DESCRIPTION**

**Patent documents cited in the description**

- WO 0163300 A